(19) Europäisches Patentamt
European Patent Office
Office européen des brevets

(11) **EP 2 775 532 A1**

(12) **EUROPEAN PATENT APPLICATION**

(43) Date of publication:
**10.09.2014 Bulletin 2014/37**

(51) Int Cl.:
*H01L 31/02* (2006.01)     *H01L 31/042* (2014.01)

(21) Application number: **13425036.4**

(22) Date of filing: **06.03.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Badini, Angelo**
**00118 Roma (IT)**

(72) Inventor: **Badini, Angelo**
**00118 Roma (IT)**

(74) Representative: **Monelli, Alberto et al**
**Bugnion S.p.A.**
**Largo Michele Novaro 1/A**
**43121 Parma (IT)**

(54) **Photovoltaic module, in particular a photovoltaic panel**

(57)     A photovoltaic module (1) comprising a support and containment structure (2), a plurality of photovoltaic groups (3) housed in the support structure (2), wherein each photovoltaic group (3) comprises a plurality of single photovoltaic cells (4) connected to each other by electric conductors (5) in a circuit with a pair of electric terminals (6), as well as reversible and switchable connection means (8) of the electric terminals to selectively connect the photovoltaic groups (3) to each other in series, in parallel, or in series and parallel in an output circuit (9) having a pair of output terminals (7).

FIG. 4

**Description**

The present invention relates to a photovoltaic module, in particular a photovoltaic panel, of the type composed of a plurality of photovoltaic cells suitable for converting incident solar energy directly into electricity by means of a photovoltaic effect.

As is known, photovoltaic modules, in particular in the form of photovoltaic panels, can be used as generators of current in photovoltaic plants, but also as generators of current for the electric recharging of mobile or portable applications such as batteries for vehicles, mobile phones or for electrically powering utilities in remote places, such as agricultural water pumps, street-lighting panels, storage batteries in high altitude mountain refuges etc.

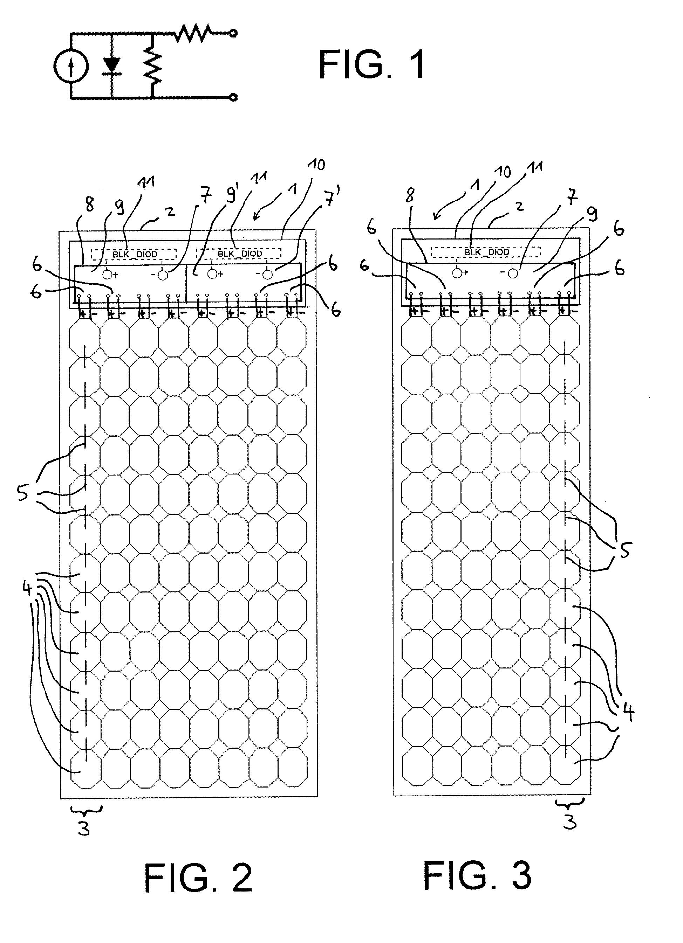

A basic element of the photovoltaic module is the single photovoltaic cell. One type of extremely widespread photovoltaic cell is the photovoltaic cell in crystalline material, composed of a ribbon of semiconductor material, in particular silicon, which transduces the incident solar energy into electricity. One mathematical model often used to analyse the functioning of a photovoltaic cell is the Shockley ideal diode equation , according to which, starting from the equivalent circuit shown in Figure 1, the current on the charge can be calculated using the formula:

$$ I - I_s - I_0 \left( e^{\frac{qV_0}{\eta kT}} - 1 \right) - \frac{V_0}{R_p} $$

in which "I" is the intensity of current running on the charge "V0" is the difference of potential between the two terminals of the diode(with 1 equal to zero), "Is" is the intensity of current produced by the generator which is proportional to the intensity of the radiation incident on the photovoltaic cell, "10" is the intensity of saturation current, a factor directly proportional to the surface of the junction p-n, "q" is the basic charge of the electron, "k" is the Boltzmann constant, "T" is the absolute temperature on the junction surface between the zone p and n, "η" is the emission coefficient generally comprised between 1 and 2, "Rp" is the parallel resistance of the model.

In the known photovoltaic modules, for example in photovoltaic modules with photovoltaic cells in monocrystalline or polycrystalline silicon, each singe photovoltaic cell is connected to the other photovoltaic cells by means of metal conductors (e.g. ribbons), so as to form series and parallel circuits. The photovoltaic cells and metal ribbons of the module are structurally combined in a structure (often multilayer) supported by a support panel and, often, by an outer frame in aluminium.

To satisfy the electricity requirements of different electric utilities with different nominal voltage, such as 6V, 12V, 18V, 24V, 36V, photovoltaic panels of different dimensions and with different numbers of individual photovoltaic cells need to be manufactured, stored and assembled. This leads to high production, installation and utilisation costs and a reduced versatility of use.

The purpose of the present invention is therefore to make available a photovoltaic module, in particular a photovoltaic panel, having characteristics such as to overcome at least some of the drawbacks cited with reference to the prior art.

One particular purpose of the invention is to propose a photovoltaic module, in particular a photovoltaic panel, having characteristics such as to be utilisable in a versatile manner with electric utilities having different nominal voltages.

A further particular purpose of the invention is to propose a photovoltaic module, in particular a photovoltaic panel, having characteristics such as to be able to supply, through the same panel, a plurality of equal or different output voltages.

A further purpose of the invention is to propose a photovoltaic module, in particular a photovoltaic panel, suitable for being made of large dimensions, without however suffering significant loss of performance in the case of shading or malfunctioning of a single cell or of a group of photovoltaic cells thereof.

At least a part of such purposes are achieved by a photovoltaic module, in particular a photovoltaic panel, comprising:

-a support and containment structure,

**[0012]** - a plurality of photovoltaic groups housed in the support structure, wherein each photovoltaic group comprises a plurality of single photovoltaic cells connected to each other by means of electric conductors in a circuit with a pair of electric terminals.

**[0013]** - reversible and switchable connection means of the electric terminals to selectively connect the photovoltaic units to each other in series, in parallel, or in series and parallel in an output circuit having a pair of output terminals.

Thanks to the reversible and switchable connection means the same photovoltaic panel can be used in a versatile manner with electric utilities having different nominal voltages.

According to one aspect of the invention, the reversible and switchable connection means are configured to connect the photovoltaic units to each other in a plurality of electrically separate circuits having a plurality of separate pairs of output terminals.

This makes it possible to make available simultaneously and by means of a single photovoltaic panel, a plurality of separate output voltages, the same or different, and thus the simultaneous electrical powering of different electric utilities.

Moreover, thanks to the reversible and switchable connection means, it is possible to exclude specific photovoltaic groups (shaded or defective) of the photovoltaic panel, so that they cannot negatively influence the functioning of the remaining photovoltaic groups.

For a better understanding of the invention and its advantages, a description of some embodiments will be provided below by way of a non-limiting example, with reference to the appended drawings, wherein:

- figure 1 shows an equivalent circuit for a photovoltaic cell;
- figure 2 is a schematic view of a photovoltaic module according to one embodiment;
- figure 3 is a schematic view of a photovoltaic module according to a further embodiment;
- figures 4- 10 show switchable connection configurations of a photovoltaic module according to embodiments of the invention;
- figure 11 is a schematic view of the structure of a photovoltaic panel according to one embodiment of the invention.

With reference to the figures, a photovoltaic module, in particular a photovoltaic panel is globally denoted by reference numeral 1. The photovoltaic module 1 comprises a support and containment structure 2, a plurality of photovoltaic groups 3 housed in the support structure 2, wherein each photovoltaic group 3 comprises a plurality of single photovoltaic cells 4 connected to each other by electric conductors 5 in a circuit with a pair of electric terminals 6, as well as reversible and switchable connection means 8 of the electric terminals to selectively connect the photovoltaic groups 3 to each other in series, in parallel, or in series and parallel in an output circuit 9 having a pair of output terminals 7.

Thanks to the reversible and switchable connection means the same photovoltaic panel can be used in a versatile manner with electric utilities having different nominal voltages.

According to one aspect of the invention, the reversible and switchable connection means 8 are configured to connect the photovoltaic groups 3 to each other in a plurality of electrically separate output circuits 9, 9' having a plurality of separate pairs of output terminals 7, 7'.

This makes it possible to make available simultaneously and by means of the same photovoltaic panel, a plurality of separate output voltages, the same or different, and thus the simultaneous electrical powering of different electric utilities.

Moreover, thanks to the reversible and switchable connection means 8, it is possible to exclude specific photovoltaic groups (shaded or defective) of the photovoltaic panel, so that they cannot negatively influence the functioning of the remaining photovoltaic groups.

According to one aspect of the invention, the pairs of electric terminals 6 of the photovoltaic groups 3 are supported by the support structure 2 in a manually accessible manner and the connection means 8 comprise electric contact bridges suitable for being reversibly connected between said electric terminals 6.

The pairs of electric terminals 6 and the pair or pairs of output terminals 7, 7' may comprise clamps, such as screw clamps, which may be housed inside a closable connection box 10, formed or connected to the support structure 2 and preferably made from self-extinguishing material. Bypass and/or blocking diodes 11 may be housed in the same box 10.

The bypass diodes are connected to the single photovoltaic groups 3 in anti-parallel in such a way as to permit the flow of current to bypass the photovoltaic group in the case of the obscuring of one or more photovoltaic cells of the group which would otherwise act as a charge.

For photovoltaic groups 3 placed in parallel block diodes may be provided for each group and connected so as to avoid the flow of currents from photovoltaic groups 3 which produce more electric current to photovoltaic groups 3 in the shade or semi-shade or defective. To such purpose, negative terminals of the photovoltaic group may be connected together directly, while the positive terminals are connected together by means of the block diodes 11.

According to one embodiment, the connection means 8 may comprise a manually operable switchable relays or system of switchable relays connected to the pairs of electric terminals 6 of the photovoltaic groups 3.

Alternatively, the connection means 8 may comprise a relay or a system of relays connected to the pairs of electric terminals 6 of the photovoltaic groups 3 and electrically operable by means of a switch or by means of keypad on the support structure 2 or remote, and connected in wireless mode or wired to the relay system.

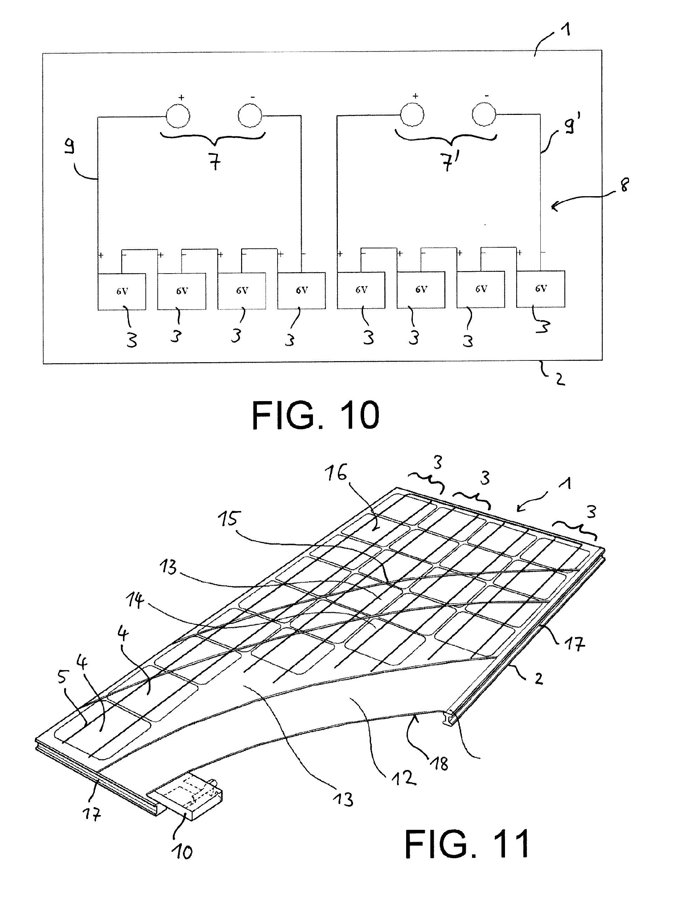

As already mentioned earlier, the photovoltaic module 1 is preferably a multilayer photovoltaic panel (Figure 11) with:

- a rigid support layer 12, for example in glass or in polyvinyl chloride (Tedlar® Du Pont), resistant to UV rays and atmospheric agents;
- one or more electrically insulating layers 13, for example in ethylene vinyl acetate (EVA) to insulate the photovoltaic cells 4 electrically from the remaining structure of the panel;
- one photovoltaic layer 14 composed of the photovoltaic cells 4, placed between two insulating layers 13;
- a transparent protection layer 15 which forms a front outer surface 16 of the panel destined to face the sun;
- possibly, but not necessarily, a peripheral frame 17, for example in aluminium, which stiffens the multilayer panel and permits its attachment to a weight-bearing structure (not shown).

The connection box 10 which houses the pairs of electric terminal 6 of the individual photovoltaic groups 3 and the pair or pairs of output terminals 7, 7', as well as the bypass and/or block diodes 11, is preferably positioned on a rear side 18 of the panel opposite the front side 16.

By way of example, the photovoltaic module 1 illustrated in figure 2 contains eight photovoltaic groups 3 each of which is configured to provide a voltage when live of approximately 6 Volts (with no-load about 9 Volts). Depending on the connections between the pairs of electric terminals 6 of the eight photovoltaic groups 3 it is possible to produce, using the same photovoltaic panel 1, output voltages of 6 Volts, 12 Volts, 18 Volts, 24 Volts, 30 Volts, 36 Volts, 42 Volts and 48 Volts.

In the same way, the example of the photovoltaic module 1 illustrated in figure 2 contains six photovoltaic groups 3 each of which is configured to provide a voltage when live of approximately 6 Volts (with no-load about 9 Volts). Depending on the connections between the pairs of electric terminals 6 of the six photovoltaic groups 3 it is possible to produce, using the same photovoltaic panel, output voltages of 6 Volts, 12 Volts, 18 Volts, 24 Volts, 30 Volt and 36 Volts.

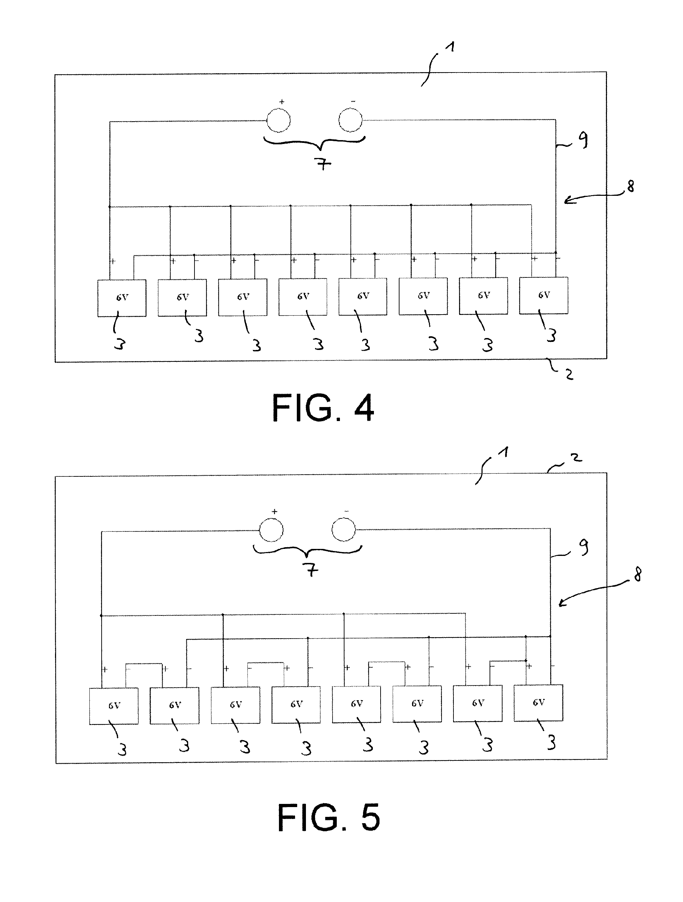

As may be seen in the example of switchable connections in figures 4 - 10, in the case in which the nominal output voltage can be achieved by just a part of the photovoltaic groups 3 of the photovoltaic panel 1, the remaining photovoltaic groups 3 may be connected in parallel to one or more of the other photovoltaic groups 3 or, alternatively, they may be connected to each other in a second output circuit 9' with a second pair of output terminals 7' for the separate supply of a further load (Figure 10).

The example of switchable connection in figure 4 shows a photovoltaic module 1 with eight photovoltaic groups 3 suitable for generating a nominal voltage of 6 V and all connected in parallel so that the photovoltaic module supplies a nominal voltage of 6 V.

The example of switchable connection in figure 5 shows a photovoltaic module 1 with eight photovoltaic groups 3 suitable for generating a nominal voltage of 6 V, wherein two groups are respectively connected in series to produce four macro-groups with nominal voltage of 12 V. The four macro-groups are connected in parallel so that the photovoltaic module supplies a nominal voltage of 12 V.

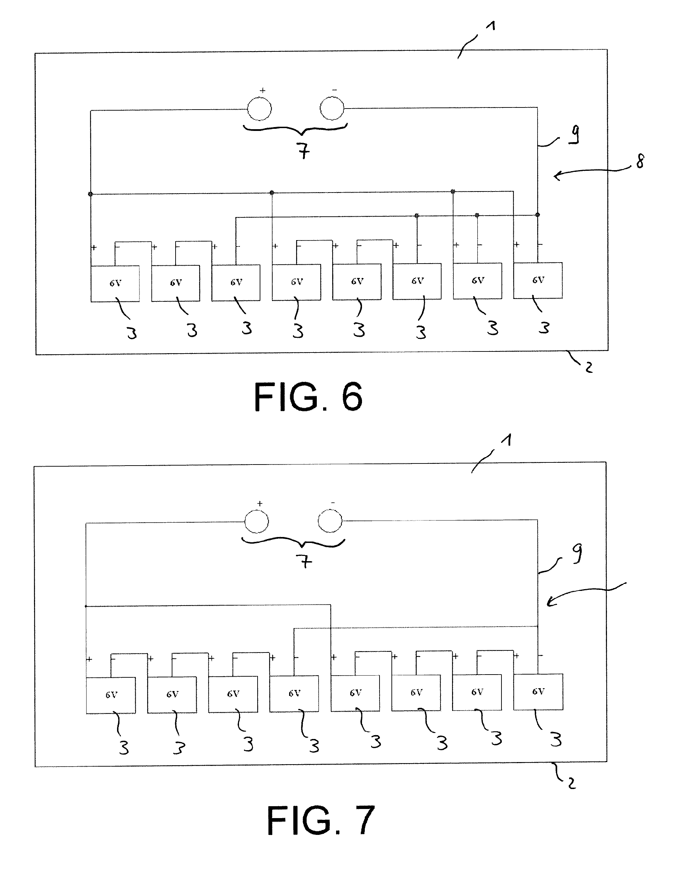

The example of switchable connection in figure 6 shows a photovoltaic module 1 with eight photovoltaic groups 3 suitable for generating a nominal voltage of 6 V and all connected in series and in parallel so that the photovoltaic module supplies a nominal voltage of 18 V.

The example of switchable connection in figure 7 shows a photovoltaic module 1 with eight photovoltaic groups 3 suitable for generating a nominal voltage of 6 V, wherein four groups are respectively connected in series to produce two macro-groups with nominal voltage of 24 V. The two macro-groups are connected in parallel so that the photovoltaic module supplies a nominal voltage of 24 V.

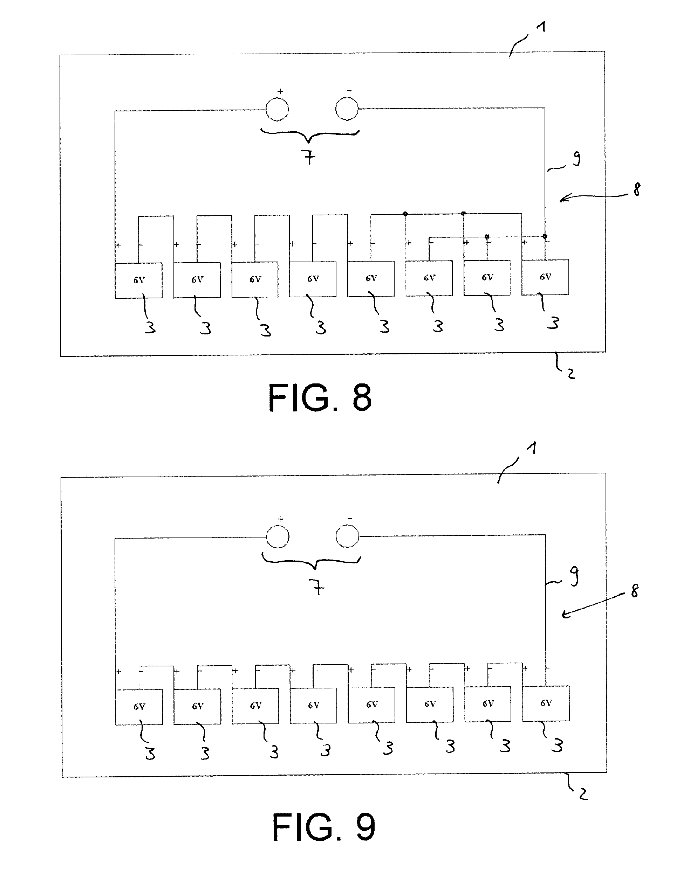

The example of switchable connection in figure 8 shows a photovoltaic module 1 with eight photovoltaic groups 3 suitable for generating a nominal voltage of 6 V, in which 5 groups are connected in series to produce a macro-group with a nominal voltage of 30 V in turn connected in series with a second macro-group of the three groups placed in parallel and thus having a nominal voltage of 6 V, so that the photovoltaic module 1 supplies a nominal voltage of 36 V.

The example of switchable connection in figure 9 shows a photovoltaic module 1 with eight photovoltaic groups 3 suitable for generating a nominal voltage of 6 V and all connected in series so that the photovoltaic module supplies a nominal voltage of 48 V.

The example of switchable connection in figure 10 shows a photovoltaic module 1 with eight photovoltaic groups 3 suitable for generating a nominal voltage of 6 V and of which four groups are connected in series and, separately, the remaining four groups in series, so that the photovoltaic module supplies two separate output voltages, both of 24 V.

Obviously, a person skilled in the art may make further modifications and variations to the photovoltaic module 1 and method according to the present invention so as to satisfy contingent and specific requirements, while remaining within the sphere of protection of the invention as defined by the following claims.

**Claims**

1. Photovoltaic module (1), comprising a support and containment structure (2), a plurality of photovoltaic groups (3)

housed in the support structure (2), wherein each photovoltaic group (3) comprises a plurality of single photovoltaic cells (4) connected to each other by electric conductors (5) in a circuit with a pair of electric terminals (6), as well as reversible and switchable connection means (8) of the electric terminals to selectively connect the photovoltaic groups (3) to each other in series, in parallel, or in series and parallel in an output circuit (9) having a pair of output terminals (7).

2. Photovoltaic module (1) according to claim 1, wherein the reversible and switchable connection means (8) are configured to connect the photovoltaic groups (3) to each other in a plurality of electrically separate output circuits (9, 9' ) having a plurality of separate pairs of output terminals (7, 7').

3. Photovoltaic module (1) according to claim 1 or 2, wherein the pairs of electric terminals (6) of the photovoltaic group (3) are manually accessible and the connection means (8) comprise electric contact bridges suitable for being reversibly connected between said electric terminals (6).

4. Photovoltaic module (1) according to claim 3, wherein the pairs of electric terminals (6) and the pair or pairs of output terminals (7, 7') comprise clamps, such as screw clamps, housed inside a connection box (10) connected to the support structure (2).

5. Photovoltaic module (1) according to any of the previous claims, wherein the connection means (8) comprise a manually operable switchable system connected to the pairs of electric terminals (6) of the photovoltaic groups (3).

6. Photovoltaic module (1) according to any of the claims from 1 to 4, wherein the connection means (8) comprise a relay system connected to the pairs of electric terminals (6) of the photovoltaic groups (3).

7. Photovoltaic module (1) according to any of the previous claims, wherein the photovoltaic module (1) is preferably a multilayer photovoltaic panel with:

   - a photovoltaic layer (14) composed of the photovoltaic cells (4),
   - a rigid support structure (12),
   - at least one electrically insulating layer (13) which insulates the photovoltaic cells (4) electrically from the remaining structure of the panel;
   - a transparent protection layer (15) which forms a front outer surface (16) of the panel destined to face the sun, wherein said connection box (10) is positioned on a rear side (18) of the panel opposite the front side (16).

8. Method of generating one or more electric currents with adjustable voltage, comprising:

   - preparing a photovoltaic module (1) comprising a support and containment structure (2), a plurality of photovoltaic groups (3) housed in the support structure (2), wherein each photovoltaic group (3) comprises a plurality of single photovoltaic cells (4) connected to each other by electric conductors (5) in a circuit with a pair of electric terminals (6),
   - connecting said electric terminals (6) of the photovoltaic groups (3) selectively to each other in series, in parallel, or in series and parallel in an output circuit (9) having a pair of output terminals (7),
   - adjusting a difference of electric potential of the pair of output terminals (7), by reversibly switching the connections between said electric terminals (6).

9. Method according to claim 8, comprising:

   - connecting said electric terminals (6) of the photovoltaic groups (3) to each other in a plurality of electrically separate output circuits (9, 9') having a plurality of said separate pairs of output terminals (7, 7').

10. Method according to claim 8 or 9, comprising selectively excluding at least one of said photovoltaic groups (3) from said output circuits.

FIG. 1

FIG. 2

FIG. 3

FIG. 4

FIG. 5

FIG. 6

FIG. 7

FIG. 8

FIG. 9

## FIG. 10

## FIG. 11

Europäisches
Patentamt
European
Patent Office
Office européen
des brevets

**EUROPEAN SEARCH REPORT**

Application Number

EP 13 42 5036

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/079412 A1 (KUO YAO HSIEN [US]) 26 March 2009 (2009-03-26) | 1-6,8-10 | INV. H01L31/02 H01L31/042 |
| Y | * paragraph [0025] - paragraph [0039]; figures 2-5 * | 7 | |
| X | US 2007/023078 A1 (PALLADINO JAMES [US]) 1 February 2007 (2007-02-01) * paragraph [0043] - paragraph [0047]; figures 1,3,4 * | 1-6,8-10 | |
| Y | US 2007/056626 A1 (FUNCELL ALELIE [US]) 15 March 2007 (2007-03-15) * paragraph [0034] - paragraph [0039]; figure 1 * | 7 | |
| A | US 2010/264742 A1 (LAI CHIH-CHEN [TW]) 21 October 2010 (2010-10-21) * paragraph [0009] - paragraph [0020]; figures 1,2 * | 1-10 | |

TECHNICAL FIELDS
SEARCHED      (IPC)

H01L

The present search report has been drawn up for all claims

| Place of search | Date of completion of the search | Examiner |
|---|---|---|
| Berlin | 15 May 2013 | Stirn, Jean-Pierre |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 13 42 5036

This annex lists the patent family members relating to the patent documents cited in the above-mentioned European search report.
The members are as contained in the European Patent Office EDP file on
The European Patent Office is in no way liable for these particulars which are merely given for the purpose of information.

15-05-2013

| Patent document cited in search report | | Publication date | Patent family member(s) | | Publication date |
|---|---|---|---|---|---|
| US 2009079412 | A1 | 26-03-2009 | NONE | | |
| US 2007023078 | A1 | 01-02-2007 | NONE | | |
| US 2007056626 | A1 | 15-03-2007 | CN | 101253643 A | 27-08-2008 |
| | | | EP | 1938405 A2 | 02-07-2008 |
| | | | US | 2007056626 A1 | 15-03-2007 |
| | | | US | 2009120487 A1 | 14-05-2009 |
| | | | US | 2010282317 A1 | 11-11-2010 |
| | | | WO | 2007033308 A2 | 22-03-2007 |
| US 2010264742 | A1 | 21-10-2010 | CN | 101873061 A | 27-10-2010 |
| | | | US | 2010264742 A1 | 21-10-2010 |

EPO FORM P0459

For more details about this annex : see Official Journal of the European Patent Office, No. 12/82